Europäisches Patentamt

European Patent Office

Office européen des brevets

(1) Publication number: **0 035 578**
**B1**

(12) **EUROPEAN PATENT SPECIFICATION**

(45) Date of publication of patent specification: **26.06.85**

(21) Application number: **80101080.2**

(22) Date of filing: **04.03.80**

(51) Int. Cl.⁴: **H 01 L 31/04**

(54) **Electromagnetic radiation transducer module.**

(43) Date of publication of application:
**16.09.81 Bulletin 81/37**

(45) Publication of the grant of the patent:
**26.06.85 Bulletin 85/26**

(84) Designated Contracting States:
**AT BE CH DE FR GB IT LU NL SE**

(56) References cited:
**DE-A-2 245 759**
**US-A-3 152 926**
**US-A-3 284 241**
**US-A-3 760 257**

(73) Proprietor: **E-Cel Corporation**
**2 Houston Center Suite 814**
**Houston, Texas (US)**

(72) Inventor: **Zwan, Bryan Joseph**
**1816 North Van Ness Avenue**
**Los Angeles California (US)**

(74) Representative: **UEXKÜLL & STOLBERG**
**Patentanwälte**
**Beselerstrasse 4**
**D-2000 Hamburg 52 (DE)**

Courier Press, Leamington Spa, England.

## Description

### Background and brief summary of the invention

The present invention relates to devices for the conversion of electromagnetic radiation into electric power, which may be used for the conversion of solar radiation into electric current.

Devices for converting or transducing electromagnetic radiation to electric power have been extensively investigated and, in view of the increasing costs of fossil fuels, attempts have been directed to improving the efficiency of solar transducers with the goal of increasing the range of applications of such devices.

The most commonly utilized device for conversion of radiant energy into electric power is known as the solar cell and which consists of the juxtaposition of materials of different electrical conductivities to form a rectifying junction which will result in the generation of current in response to exposure to solar radiation. Typically, most solar cells have a single P/N junction formed from oppositely doped semi-conductor material.

The solar cells of the prior art are responsive to only a portion of the energy extent in the solar spectrum and thus have a limited capability to convert broad band electromagnetic radiation into electric power. The major energy loss as a result of this limitation is believed to be approximately 50%. In addition, other losses are known to be caused by the structure of the solar cells and the particular arrangement and types of materials used to construct the cells.

It is the object of the present invention to provide a novel solar cells which will exhibit enhanced efficiencies in converting incident radiation, particularly solar radiation, to electric power relative to what was obtainable by the devices of the prior art.

It has been the practice to select materials for solar cells where the amount of incident light quanta that is converted to electrical energy is maximized relative to the heat losses. That this was necessary can be appreciated from the following explanation.

Impinging light quanta of a specific wavelength can, through excitation of the solar cell material, make available for conduction an electron-hole pair. If an electron-hole pair is created near the junction, charge separation occurs and, if collected, current is generated. The electron-hole pair creation occurs over a broad band of wavelengths of the incident solar radiation, but it is required that the energy of the electromagnetic quantum be greater than or equal to the energy difference between the conduction band and the valence band of the material to create the electron-hole pair. However, for a given quantum, only an amount of energy equal to the band gap, that is, the difference between the conduction band and valence band energy levels, is converted to an electron-hole pair and any energy in excess of the band gap value is converted into heat. Light quanta with energies below the band gap value excite no electron-hole pairs. Use of material in solar cells with a small band gap relative to the incident electromagnetic spectrum increases the relative amount of energy available for absorption but also increases the relative loss of energy due to heating. As the band gap decreases, the heat loss increases, thereby limiting the selection of material that can be used to optimize the power output versus the heat losses of a given solar cell.

As a result of the foregoing, the solar cells of the prior art have been so constructed as to convert only a narrow range of incident solar radiation to electric power, thus reducing their energy conversion efficiency.

It is also known that in presently available solar cells, the output of the cells is an indication of the depth to which the incident quanta penetrate before they are absorbed. This is so since, for charge separation of an electron-hole pair, absorption of quanta must occur near a junction. As a result, it has been necessary to improve the physical design of the junction in terms of its profile in order to improve the conversion factor of the cell. However, such requirements are both difficult and expensive in view of the types of materials that can be used relative to their absorption characteristics.

In constructing solar cells, another important factor has been the criticality of the condition of the material that is used in the construction of the cell. As the output power of a solar cell is derived only from charged carriers which reach the collection electrode, any photocarrier recombination is a loss which diminishes the cell's overall efficiency. As photocarriers diffuse towards the electrode, they encounter a series resistance which must be kept low for nominal energy conversion. Thus, the most efficient devices must be fabricated from extremely pure and defect-free single crystals of low resistivity in order to enhance the photocarrier lifetime and to reduce the series resistance. However, the manufacture of such crystals at present is very expensive, thus limiting the commercial market for this type of power source.

There are other factors which adversely affect the efficiencies of solar cells, such as the temperature, the saturation or dark current, and junction losses which, alone, account for between 38% and 45% loss in output voltage of silicon cells.

To overcome these losses, attempts have been made to improve the character and quality of the materials employed in the construction of the cells as well as their arrangement, but efficiencies higher than 22%, it is believed, can only be achieved at great expense.

The transducer module of the present invention overcomes the foregoing disadvantages while providing a solar radiation module or cell which will exhibit improved performance in converting broad band electromagnetic radiation to useful electric energy at greater efficiencies than heretofore available.

In particular, the structure of the cell or module of the present invention can be given such a dimension that incident radiation will be absorbed and transduced in resonance with the frequency of the impinging quanta by using cavities formed on a substrate of specific shape and dimension and with a specific junction profile. With the arrangement of the present invention, quanta of different wavelengths and total energy will be available for conversion to electrical energy which, heretofore, was either lost by absorption or by heat losses.

Of particular interest is the fact that the structure and material or group of materials used in the transducer module of the present invention will not require pure, single, defect-free crystals for energy conversion, but, instead, the present invention utilizes materials that are shaped to match a characteristic of the incident radiation, thereby minimizing junction profiling losses that have been encountered in prior art structures.

In a preferred embodiment, an electromagnetic radiation transducer module is provided which consists of a plurality of cavities formed on a substrate where each cavity has an inwardly sloping wall structure. Situated on or as a part of the inwardly sloping wall of each cavity are one or more potential barrier strips of dissimilar material. The strips extend from the mouth of the cavity to the base thereof to divide the interior of the cavity into two surface areas. The walls of the cavity may be of one material such as aluminum, where the potential barriers strips are of two dissimilar materials having different work functions. At the edges of each strip there is created a potential barrier which exhibits non-linear, current-voltage characteristics. At the mouth of the cavities, the strips are connected to conductors or electrodes having the specific work functions of the associated strip. The cavities of a module may be connected in series or parallel with one another to suit the specific application of the module.

The dimensions of the cavity can be selected so that the mouth of the cavity will admit radiation corresponding to roughly the longest wavelenth in the solar spectrum while the base of the cavity has dimensions which are on the order of or smaller than the shortest wavelength, approximately, in the solar spectrum. The cavities are electrically insulated from each other except through the electrodes connected to the potential barrier strips.

With this arrangement, the cavities can be made extremely shallow so that the resulting module can be constructed on a flexible substrate. Further, it is no longer necessary to use extremely pure, defect-free single crystal material, thus resulting in a considerable saving in the cost of manufacturing the modules. Further, the efficiency, in terms of the transducing function of the module, will be relatively high compared to what was available in the prior art and yet will provide a high ratio of output wattage to the weight of the module.

These and other objects and advantages of the present invention will become apparent as consideration is given to the following detailed description which is given in conjunction with the accompanying drawings, in which:

Brief description of the drawings

Figure 1 is a plan view of a portion of a module a preferred embodiment of the present invention having a plurality of cavities with two of such cavities being illustrated;

Figure 2A is a sectional view taken along line 2A—2A of Figure 1;

Figure 2B us a view taken along line 2B—2B of Figure 1;

Figure 2C is a view taken along line 2C—2C of Figure 1; and

Figure 3 is a schematic illustration of a plurality of cavities of the embodiment of Fig. 1 connected in parallel.

Detailed description of the invention

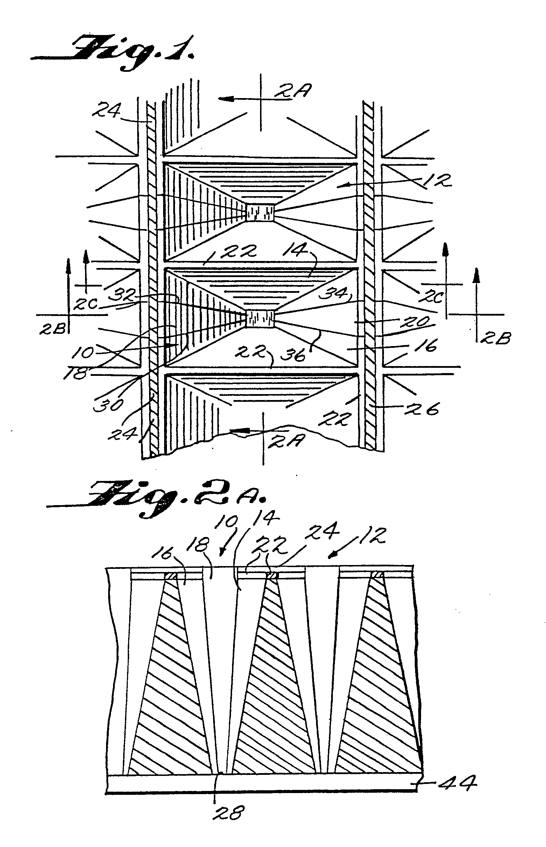

Referring now to Figure 1, there is shown a portion of a transducing module which consists of a plurality of juxtaposed cavities, two of which are indicated at 10 and 12. In the illustrated embodiment, each of the cavities is in the shape of an inverted, truncated pyramid having inwardly sloping side walls but it should be understood that all that is required is that the mouth of each cavity be symmetrical about a central axis of each cavity and that the area enclosed by the side walls decreases as the depth of the cavity increases. Thus, the cavities can also be shaped as hemi-ellipsoids or as hemispheres.

In a preferred embodiment, the side wall or interior surface of each cavity is divided into two sections 14 and 16 by two strips of dissimilar material 18 and 20. The wall sections 14 and 16 are made from or coated with a material having a given work function $\phi_1$. The term work function as employed herein means the minimum energy necessary for an electron to escape into vacuum from an initial energy level. It is usually more accurately measurable that the conduction electron density of a material. The strips 18 and 20 are each made from or coated with a material having different work functions $\phi_2$ and $\phi_3$.

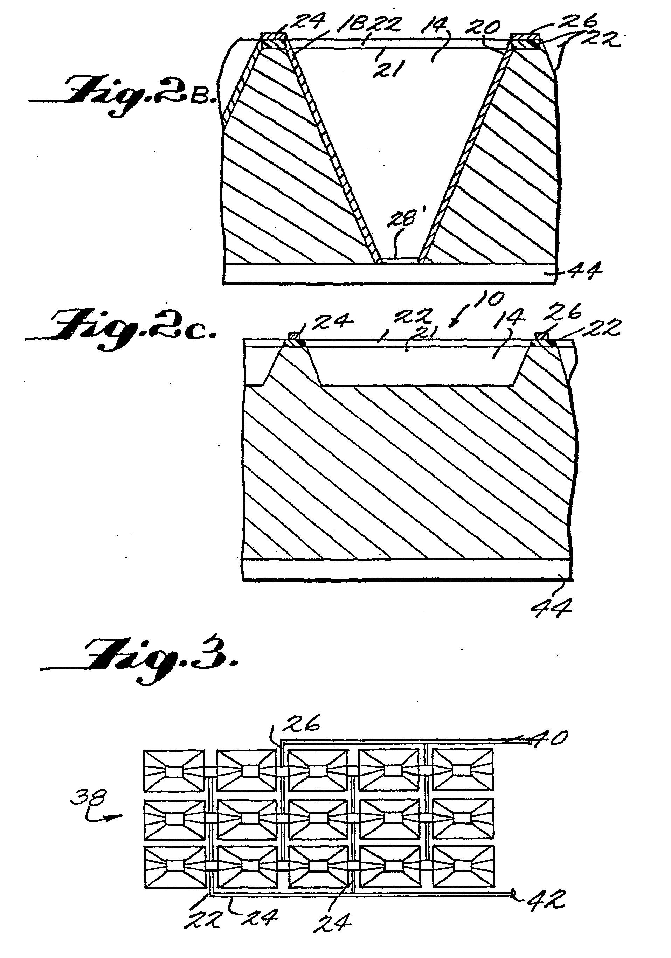

As shown more clearly in Figures 2A and 2B, the mouth 21 of each of the cavities is surrounded by an insulation barrier strip 22. The material of strips 18 and 20 extends beyond the mouth 21 of each cavity and each of the strips 18 and 20 is electrically connected to separate conducting strips 24 for strip 18 and 26 for strip 20, each of which may have the same function value as the associated barrier strip.

Alternatively, each of the conductors 24 having a work function $\phi_4$, and 26 having a work function $\phi_5$ can be of a material which ohmically contacts to strips 18 and 20 respectively, or can be fabricated with the same material as 18 and 20 respectively so that the following relationship applies;

$$\phi_2 < \phi_1 < \phi_3 \text{ and } \phi_4 \approx \phi_2; \phi_5 \approx \phi_3$$

The juxtaposition of strip 20 and the material of wall section 14 and 16 results in the formation of potential barriers 34 and 36 respectively, each of which exhibits non-linear current-voltage characteristics. The direction of forward bias results from strip 20 being negative with respect to either of the wall sections so that electrons flow from the strip into the particular wall section which is at the positive potential. There are similarly created potential barriers 32 and 30. The forward bias direction for these is for strip 18 being positive with respect to either wall section.

An incident electromagnetic wave impinging on a cavity 10 will resonate within the cavity structure, its energy absorbed or attenuated due to the finite impedance of the walls. The electric field of the wave will induce a wall current across potential barriers 30, 32 and 34 and 36. The strips 18 and 20 will act to rectify the wave-induced wall current and will deliver the rectified current to the conducting strips 24 and 26. Thus, a continuous cavity loop of conducting surfaces 14, 20, 16 and 18 acts contiguously as a full wave rectifier bridge circuit and with direct current output to conducting strips 24 and 26.

As shown in Figure 3, the various cavities of a transducing module 38 are connected in parallel to the conducting strips 24 and 26 where conductor 24 has a terminal 42 and conductor 26 has a terminal 40 across which the output power of the module can be delivered to an external load. It will be apparent to those skilled in this art that other combinations of series or parallel circuits can be arranged to achieve a desired voltage and current output for the foregoing and other arrangements of the cavities.

In a preferred embodiment, the surfaces 14 and 16 may be a metal such as aluminum with the strips 18 and 20 each being a semiconductor material of different types, one being a P-type, while the other being an N-type. In most cases, the metal work function, $\phi_1$, in this embodiment, would be greater than the semiconductor work function for the N-type, and less than the semiconductor work function for the P-type. Alternatively, the surfaces 14 and 16 may be a metal and the barrier strips 18 and 20 may also be a metal with the potential barriers 30—36 being an oxide of one of the metals, or an insulating material such as $SiO_2$. In this example, the metal work function of sections 14 and 16, about 4.25 electron volts for molybdenum, would be greater than the work function for metal strip 20, e.g., 4.08 ev for aluminum, while being less than the work function of strip 18, e.g., 4.82 for gold. The width of metal oxide may be on the order of 10 nm.

Of particular importance is the correct selection of the size of the cavity. In order to efficiently convert solar energy to electric current, the cells must convert radiation having a wavelength in the range of 0.30—2.0 microns, wherein is contained approximately 95% of the energy of the solar spectrum. The cavity dimensions should therefore enable each cavity to absorb and transduce throughout this range so that cavity dimensions on the order of a micron would be required. Thus, the surface area of the mouth of each cavity should be large enough to admit solar radiation having a wavelength as large as 2.0 microns while the base 28 of the cavity should have a surface area that is on the order of the square of the shortest wavelength in this range of the solar radiation spectrum. The depth of each cavity should then be on the order of several wavelengths of the center wavelength of the spectrum.

As an example, it is believed that the largest dimension of the mouth of each of the cavities should be no larger than five times the longest wavelength in any particular wavelength band of the solar radiation spectrum and no smaller than the longest wavelength. The area of the base of each cavity should be less than 10 times the square of the shortest wavelength in a particular band. The distance from the mouth to the base along the axis of each cavity should be less than 10 times the longest wavelength in the band but greater than one-quarter wavelength of the longest wavelength in the band. Such dimensions will give suitable latitude in manufacturing the modules and it will be obvious that as the dimensions of the mouth and base vary, the depth of each cavity will vary.

It will be readily appreciated that the volume enclosed by the cavities need not be a truncated cone, as illustrated, but may also be hemispherical or hemiellipsoidal.

Manufacture of such cavities can be accomplished by presently available ion milling techniques in combination with X-ray lithography as well as other methods known in the art.

In view of the relatively small dimensions of the cavities, the resulting modules 38 need not be rigid. Indeed, the cavities can be formed by depositing a metal layer on a plastic film substrate 44 such as Mylar (registered trade mark) which need not be rigid. Also, the cavities can be formed on a glass substrate for applications where weight is not a critical factor. Also, the completed cavities can be filled with a transparent dielectric material as a protective layer. It will also be apparent that, when in use, the maximum transducing efficiency will be achieved where the modules extend transverse to the direction of propagation of the incident radiation.

While the foregoing embodiment shows the use of a pair of barrier strips 18 and 20, a single barrier strip 18 can be employed with the conducting strip 26 then connected electrically to the material of the walls 14 and 16. However, such an arrangement will provide a somewhat lower power output. Also, it is not necessary that the barrier strips 18 and 20 be located opposite one another in each cavity, although this arrangement may be more attractive from a manufacturing standpoint. Although the emphasis has been on conversion of solar radiation, it should be clear that the invention is not limited to converting these frequencies and in particular can be utilized in the infrared.

## Claims

1. A transducer module for conversion of electromagnetic radiation into electric power comprising a body having a plurality of cavities (10, 12), each cavity (10, 12) having a mouth (21) and a base (28), an interior surface (14, 16) extending from said mouth (21) to said base (28) and surrounding a central axis, said interior surface (14, 16) enclosing a progressively smaller area along said axis from said mouth (21) to said base (28), said interior surface (14, 16) including one or more potential barrier strips, (18, 20) each having opposite edges (30, 32; 34, 36) said interior surface (14, 16) being made outside the strip area from a material having a given work function $\phi_1$ while said potential barrier strips (18, 20) are each made from a material having a work function that is different from the work functions of other barrier strips and from said given work function $\phi_1$, said barrier strips (18, 20) extending from said mouth (21) to said base (28) and being each in contact with said interior surface (14, 16) along their respective edges (30, 32; 34, 36) each of said barrier strips (18, 20) of each cavity (10, 12) being connected adjacent to each said mouth (21) to a separate conductor (24, 26) wherein insulation means (22) are provided to electrically insulate said conductors (24, 26) from said body.

2. The transducer module as claimed in claim 1, wherein said conductors (24, 26) are made from the same material as the associated potential barrier strip (18), respectively.

3. The transducer module of claim 1, wherein a single potential barrier strip is provided and the interior surface outside the strip is electrically connected to a conductor.

4. The transducer module of claim 3, wherein a first conductor, connected to the potential barrier strip, is made from the same material as the potential barrier strip, and a second conductor, connected to the interior surface outside the strip is made from the same material as the interior surface outside the strip.

5. The transducer module as claimed in any of claims 1 to 4 wherein said interior surface (14, 11) outside the strip area is metal of one work function and each potential barrier strip (18, 20) is made of another metal of different work function.

6. The transducer module as claimed in any of claims 1 to 4 where said interior surface (14, 16) outside the strip area is metal of work function $\phi_1$ and one of said potential barrier strip is a P-type semiconductor of semiconductor work function $\phi_2$ where:

$$\phi_1 < \phi_2.$$

7. The transducer module as claimed in any of claims 1 to 4 where said interior surface (14, 16) outside the strip area is metal of work function $\phi_1$ and one of said potential barrier strips (18) is a N-type semiconductor of semiconductor work function $\phi_2$ where:

$$\phi_2 < \phi_1.$$

## Patentansprüche

1. Wandlermodul zur Umwandlung von elektromagnetischer Strahlung in elektrische Leistung, mit einem Körper, der eine Anzahl von Hohlräumen (10, 12) aufweist, wobei jeder Hohlraum (10, 12) eine Öffnung (21) une eine Basis (28), eine sich von der Öffnung (21) zu der Basis (28) erstreckende Innenwand (14, 16) aufweist, welche eine Mittelachse umgibt, wobei die Innenwand (14, 16) eine fortlaufend kleiner werdende Fläche um die Achse von der Öffnung (21) zu der Basis (28) umschließt und wobei die Innenwand (14, 16) einen oder mehrere Potentialbarrierestreifen (18, 20) aufweist, die jeweils gegenüberliegende Ränder (30, 32; 34, 36) haben und wobei die Innenwand (14, 16) außerhalb des Streifenbereichs aus einem Material gemacht ist, die eine bestimmte Austrittsarbeit $\phi_1$ hat, während die Potentialbarrierenstreifen (18, 20) jeweils aus einem Material gemacht sind, welches eine Austrittsarbeit hat, die sich von den Austrittsarbeiten anderer Barrierenstreifen und von der gegebenen Austrittsarbeit $\phi_1$ unterscheiden, wobei sich die Barrierestreifen (18, 20) von der Öffnung (21) zu der Basis (28) erstrecken und jeweils in Kontakt mit der Innenwand (14, 16) entlang ihrer jeweiligen Ränder (30, 32; 34, 36) stehen, wobei jeder der Barrierestreifen (18, 20) jedes Hohlraums (10, 12) in der Nähe jeder Öffnung (21) mit einem getrennten Leiter (24, 26) verbunden ist, und wobei Isolierungsmittel (22) vorgesehen sind, um die Leiter (24 und 26) von dem Körper elektrisch zu isolieren.

2. Wandlermodul nach Anspruch 1, dadurch gekennzeichnet, daß die Leiter (24, 26) jeweils aus dem gleichen Material wie die zugehörigen Potentialbarrierestreifen (18) gemacht sind.

3. Wandlermodul nach Anspruch 1, dadurch gekennzeichnet, daß ein einziger Potentialbarrierestreifen vorgesehen ist und daß die Innenwand außerhalb des Streifens elektrisch an einen Leiter angeschlossen ist.

4. Wandlermodul nach Anspruch 3, bei dem ein erster Leiter, der an den Potentialbarrierestreifen angeschlossen ist, aus dem gleichen Material wie der Potentialbarrierestreifen gemacht ist und bei dem eine zweiter Leiter, der an die Innenwand außerhalb des Streifens angeschlossen ist, aus dem gleichen Material wie die Innenwand außerhalb des Streifens besteht.

5. Wandlermodul nach einem der Ansprüche 1 bis 4, dadurch gekennzeichnet, daß die Innenwand (14, 16) außerhalb des Streifenbereichs ein Metall mit einer ersten Austrittsarbeit und jeder Potentialbarrierestreifen (18, 20) aus einem anderen Metall mit anderer Austrittsarbeit besteht.

6. Wandlermodul nach einem der Ansprüche 1 bis 4, dadurch gekennzeichnet, daß die Innenwand (14, 16) außerhalb des Streifenbereichs ein Metall mit einer Austrittsarbeit $\phi_1$ und einer der Potentialbarrierestreifen ein p-Halbleiter mit einer Halbleiter-Austrittsarbeit $\phi_1$ ist, wobei: $\phi_1 < \phi_2$.

7. Wandlermodul nach einem der Ansprüche 1 bis 4, wobei die Innenwand (14, 16) außerhalb des Streifensbereichs Metall der Austrittsarbeit $\phi_1$ und einer der Potentialbarrierestreifen (18) ein n-Halbleiter mit einer Halbleiter-Austrittsarbeit $\phi_2$ ist, wobei: $\phi_2 < \phi_1$.

## Revendications

1. Module transducteur pour la conversion du rayonnement électromagnétique en énergie électrique, comprenant un corps présentant une pluralité de cavités (10, 12), chaque cavité (10, 12) ayant une embouchure (21) et une base (28), une surface intérieure (14, 16) s'étendant de ladite embouchure (21) vers ladite base (28) et entourant un axe central, ladite surface intérieure (14, 16) délimitant une zone de surface décroissant progressivement le long dudit axe depuis ladite embouchure (21) vers ladite base (28), ladite surface intérieure (14, 16) comprenant une ou plusieurs bandes de barrière de potential (18, 20) chacune ayant des bords opposés (30, 32; 34, 36), ladite surface intérieure (14, 16) étant réalisée à l'extérieur de la zone de la bande en un matériau ayant une fonction de travail donnée $\phi_1$, alors que lesdites bandes de barrière de potentiel (18, 20) sont chacune en un matériau ayant une fonction de travail qui est différente des fonctions de travail des autres bandes de barrière et de ladite fonction de travail donnée $\phi_1$, lesdites bandes de barrière (18, 20) s'étendant depuis ladite embouchure (21) jusqu'à ladite base (28) et étant chacune en contact avec ladite surface intérieure (14, 16) le long de leurs bords respectifs (30, 32; 34, 36), chacune des bandes de barrière (18, 20) de chaque cavité (10, 12) étant reliée au voisinage de chaque embouchure (21) à un conducteur séparé (24, 26), des moyens d'isolement (22) étant prévus pour isoler électriquement lesdits conducteurs (24 et 26) dudit corps.

2. Module transducteur selon la revendication 1, dans lequel lesdits conducteurs (24, 26) sont du meme matériau que la bande de barrière de potential respective associée (18).

3. Module transducteur selon la revendication 1, comprenant une seule bande de barrière de potentiel, la surface interieure à l'extérieur de la bande étant reliée électriquement à un conducteur.

4. Module transducteur selon la revendication 3, dans lequel un premier conducteur, relié à la bande de barrière de potentiel, est du meme matériau que la bande de barrière de potentiel, et dans lequel un second conducteur, relié à la surface intérieure à l'extérieur de la bande est du meme matériau que la surface intérieure à l'extérieur de la bande.

5. Module transducteur selon l'une quelconque des revendications 1 à 4, dans lequel ladite surface intérieure (14, 16) à l'extérieur de la zone de bande, est en un métal d'une certaine fonction de travail et, chaque bande de barrière de potentiel (18, 20) étant en un autre métal ayant une fonction de travail différente.

6. Module transducteur selon l'une quelconque des revendications 1 à 4, dans lequel ladite surface intérieure (14, 16) à l'extérieur de la zone de bande, est en un métal ayant une fonction de travail $\phi_1$, l'une des bandes de barrière de potentiel étant en un semiconducteur du type P remplissant une fonction de travail semi-conductrice $\phi_2$, avec $\phi_1 < \phi_2$.

7. Mobile transducteur selon l'une quelconque des revendications 1 à 4, dans lequel ladite surface intérieure (14, 16) à l'extérieur de la zone de bande est en un métal ayant une fonction de travail $\phi_1$, l'une des bandes de barrière de potentiel (18) étant en un semiconducteur du type N remplissant une fonction de travail semi-conductrice $\phi_2$, avec $\phi_2 < \phi_1$.

*Fig. 1.*

*Fig. 2A.*

*Fig.2B.*

*Fig.2c.*

*Fig.3.*